# EUROPEAN PATENT APPLICATION

(11) **EP 1 150 348 A1**
(43) Date of publication of application: **31.10.2001**
(21) Application number: 00309837.3
(22) Date of filing: 06.11.2000
(51) Int. Cl.: H01L 21/8234

(54) **A process for fabricating an integrated circuit that has embedded dram and logic devices**

(30) Priority: 26.04.2000 US 559212
(71) Applicant: LUCENT TECHNOLOGIES INC., Murray Hill, New Jersey 07974-0636 (US)
(72) Inventor: Diodato, Philip W., Asbury, New Jersey 08802 (US); Liu, Chun-Ting, Berkeley Heights, New Jersey 07922 (US)
(74) Representative: Williams, David John

(57) **Abstract**

A process for fabricating an embedded DRAM device and a logic device on a common semiconductor substrate is disclosed. In the process, a logic device region and a DRAM device region are formed in the substrate by selectively introducing dopants into discrete regions of the substrate. Field oxide regions are formed to electrically isolate the various regions of the substrate. The gate oxide and the gates are then formed. The source and drain of the devices are formed by ion implantation. The source and drains are formed by a first implant of arsenic, followed by a second implant of phosphorus. The phosphorus implant conditions are selected by first determining the damage to the semiconductor substrate and the location of that damage relative to the junction of the device. The phosphorus implant conditions are then selected to cause the location of the junction to move relative to the damage caused by the arsenic implant.

## Description

### BACKGROUND OF THE INVENTION

### Technical Field

The present invention is a process for fabricating an integrated circuit and, more particularly, an integrated circuit with embedded DRAM devices and logic devices.

### Art Background

Application specific integrated circuits (ASIC), such as system-on-a-chip products, require both embedded dynamic random access memory (DRAM) cells and logic circuits on a single chip. This integration improves performance by decreasing undesirable delays that occur between memory devices, located on one semiconductor chip, and logic devices located on another semiconductor chip. However, the performance requirements for the devices in the DRAM cells are completely different from the performance requirements for the devices in the logic circuits. Different performance requirements for these devices have made it difficult to integrate the fabrication sequence of the devices in the DRAM cells with the fabrication sequence of the logic devices.

For example, when both the devices in the DRAM cells and the logic devices are MOSFET (metal-oxide-semiconductor field effect transistor) devices, the logic MOSFET devices are required to have a high (about 0.75 mA/µm) current drive in the on state. To obtain this high current drive, the tradeoff is high leakage of current in the off state. Consequently, the leakage control for the logic MOSFET devices is not very strict (about 1 nA/device at 25°C and greater than 1 nA/device at 125°C). Conversely, the leakage control for the DRAM MOSFET devices is very strict (e.g., less than 160 fA/cell at 125°C) in order to satisfy the requirements for the memory data retention time.

In conventional processes for fabricating MOSFET devices, impurities (i.e. dopants) are introduced into a semiconductor to form conductive regions therein. The dopants are either n-type (e.g. arsenic, phosphorus) or p-type (e.g. boron). Typically, the dopants are introduced into the substrate by ion implantation. In ion implantation, dopant atoms are accelerated toward the substrate using high energy on the order of tens to hundreds of keV. The amount of energy for a particular implant will depend on the size of the dopant atoms and the depth to which they will be introduced into the substrate.

It is well known that ion implantation damages the semiconductor substrate. Specifically, the semiconductor substrate is a crystalline structure, and the crystalline structure is damaged by the ion implantation. It is also well known that damage to the crystal structure directly effects the leakage of the device if the damage is within a certain proximity to the junction of the device. The junction of the device is the interface region between a p-type doped region and an n-type doped region.

Individual devices are being made smaller in size in order to accommodate the need to place more devices on a single integrated circuit chip. As a result of the smaller scaling, the depth of the source and drain regions in the substrate is also decreasing. The consequence is that the damage to the silicon substrate that results from ion implantation to form the source and drain is closer to the surface of the substrate. The closer the damage is to the surface of the substrate, the greater the device leakage that results from this damage.

As the device size (typically referred to as the design rules) decreases below 0.18 µm, the leakage that results from ion implantation of arsenic to form n-type source and drains for embedded DRAM devices is increasing above the acceptable limit (on the order of 100 fA/cell at 125°C for 0.16 µm devices). Consequently, processes for forming the source and drain of embedded DRAM devices in which the damage from ion implantation is controlled are being sought. Since it is also desired to form embedded DRAM and logic devices on a single chip, the processes for forming the source and drain of the embedded DRAM devices must be compatible with the process for forming the logic devices.

### SUMMARY OF THE INVENTION

The present invention is directed to process for fabricating high performance MOSFET logic devices and embedded DRAM memory devices on a single semiconductor chip. The present process utilizes a series of ion implant steps to control the leakage current of the DRAM device. In the context of semiconductor devices, leakage current is current that "leaks" or otherwise travels through the device when the device is in the off state. Leakage is therefore undesirable because it dissipates current when the device is in the off state.

As previously noted, the acceptable amount of leakage current depends upon the type of device (i.e. logic or DRAM) and the size of the device (0.18 µm, 0.16 µm, etc.). The present process produces logic FETs and embedded DRAM devices that meet their respective performance requirements without requiring the gate dielectric of the DRAM devices to be thicker than the gate dielectric of the logic FET devices. Different gate dielectric thicknesses has been proposed as a solution for making embedded DRAM devices and MOSFET devices on a common substrate in order for the leakage of the DRAM devices to be at or below the required levels.

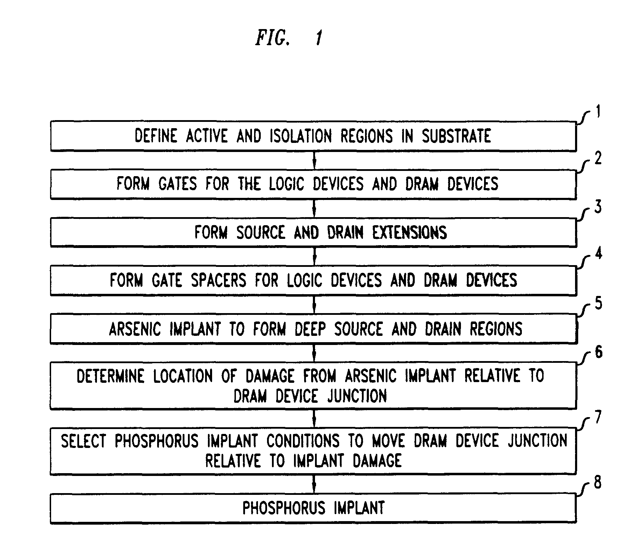

An example of a process flow for fabricating DRAM and MOSFET devices is described generally with reference to the flow chart in FIG. 1.

Referring to block 1, active and isolation regions for the logic and DRAM devices are first formed in the semiconductor substrate. The DRAM devices are n-channel. The logic devices are either n-channel or p-channel. Consequently, it is advantageous if at least some of the logic devices are n-channel devices, in order to obtain the processing efficiencies of forming devices of the same channel type in both the logic and DRAM regions.

For the n-channel devices, p-tub regions (i.e. a region of the semiconductor device that is lightly doped with a p-type dopant (e.g. boron)) are formed for both the MOSFET logic devices and the DRAM devices. After the p-tubs are formed, an n-well region and a buried n-layer are formed to isolate the DRAM p-tub from the MOSFET p-tub. The p-tubs, n-well and buried n-layer are formed by implanting dopants into the substrate. Materials and conditions for implanting dopants into semiconductor substrates are well known to one skilled in the art and are not described in detail herein.

Field oxide regions are formed using shallow trench isolation to electrically isolate the devices as required by the circuit design. Processes and conditions for forming the doped regions and the field oxide regions are conventional to one skilled in the art and are not discussed in detail herein.

Referring to block 2, a gate dielectric layer is then formed on the semiconductor substrate. The gate dielectric material is typically silicon dioxide (i.e. the gate oxide), although other gate dielectric materials are contemplated as suitable. It is advantageous if the gate oxide layer is the same thickness in the logic MOSFET region and the DRAM region. Typically, the thickness of the gate oxide is about 1 nm to about 10 nm. Materials and conditions for forming the thin layer of gate oxide are well known to one skilled in the art and are not described in detail herein.

The gates of the MOSFET and DRAM devices are then formed. The gates are formed using conventional processes. In one embodiment of the present invention, a layer of polycrystalline silicon is first formed over the substrate. The polycrystalline layer is then doped. Conventional expedients for introducing dopant into polycrystalline silicon are contemplated as suitable. Such expedients are well known to one skilled in the art and are not discussed in detail herein. The doped polycrystalline layer is either doped in situ while it is formed or dopant is implanted into a previously formed polycrystalline layer. The gates are then lithographically defined in the polycrystalline layer.

Referring to block 3, n-type dopant is then implanted into the n-channel MOSFET devices. The polycrystalline gate masks the channel region of the MOSFET device from the implant and defines the implant region. In the process of the present invention, it is advantageous if the DRAM devices are masked during this implant step. As a consequence of masking the DRAM region during this step, source and drain extensions are not formed for the DRAM devices. The advantages that derive from not forming source and drain extensions for the DRAM devices is discussed more fully in commonly assigned U.S. Serial No. 08/938,755, which is incorporated by reference herein.

Referring to block 4, dielectric spacers (i.e. spacers made of an electrically insulating material such as silicon dioxide) are then formed by first depositing a layer of silicon dioxide over the silicon substrate. The dielectric layer is then etched using an anisotropic etch expedient (e.g. a plasma etch) to form spacers adjacent to the gates in both the MOSFET logic region and the DRAM region. Materials and conditions for forming dielectric spacers are conventional and not described in detail herein. The width of the dielectric layer is selected to provide a spacer of a desired width (i.e. the spacer width is the portion of the underlying substrate covered by the spacer in the direction of the device channel). The spacers and the polycrystalline gate serve as a mask for the subsequent source and drain implants. Consequently, the thickness of the dielectric layer is selected to provide spacers that, in turn and in combination with the gates, define the source and drain regions for the devices.

Referring to block 5, after the spacers are formed, arsenic is implanted into the substrate to form the source and drain regions therein. The implant conditions (i.e. energy and dose) are selected to provide a junction with a depth of about 0.1µm to about 0.15µm. Devices with such junction depths are n-type at the surface, but the substrates are p-type below that depth. The conditions (i.e. energy and dose) for such implants are a matter of design choice and are well known to one skilled in the art. Consequently, the materials and conditions for the implants are not discussed in detail herein. One example of suitable arsenic implant conditions is an energy of 30keV and an arsenic dose of 3 x 10¹⁵ atoms/cm².

As a result of this implant, the source and drain regions will have a certain depth in the substrate. The depth is readily ascertained by one skilled in the art. For example, with an implant energy in the range of 30keV to 50keV and a subsequent rapid thermal anneal at 1050°C for about 10 seconds, the location in the substrate of the defects caused by the implant damage are 50 nm to 100 nm from the surface. The phosphorus implant conditions are selected to move the location of the source and drain junctions. The direction of movement is outward from the junction boundary after the arsenic implant and subsequent anneal (if any). If movement of the location of the source and drain regions of the logic devices is not desired, the logic devices are masked prior to this implant.

Movement is away from the region of the substrate that was damaged by the arsenic implant. Consequently, referring to block 6, before the phosphorus implant conditions are selected, the location of the damage in the substrate from the arsenic implant must be ascertained. Then, referring to block 7, the conditions for the phosphorus implant that are required to move the junction away from the damage caused by the arsenic implant are determined.

The phosphorus implant conditions are determined by the placement (i.e. width and/or depth) of the junction depletion region in the substrate. The placement of the junction depletion region is defined by the implant conditions (i.e. implant energy and dose). The placement of the junction depletion region is readily ascertained by one skilled in the art. The objective is to move the junction (defined as the interface between the n-type region and the p-type region in the substrate) as well as the associated depletion region away from the defect region. In order to move the location of the junction in an outward direction (i.e. deeper into the substrate), the depth of the phosphorus implant (i.e. the depth in the substrate of the peak phosphorus concentration) in the substrate exceeds the depth of the arsenic profile in the substrate. After the conditions for the phosphorus implant are determined, the phosphorus is implanted into the substrate (block 8).

After the phosphorus implant, the integrated circuit is completed by forming the interconnects for the logic devices, and the interconnects and capacitors for the DRAM devices.

### BRIEF DESCRIPTION OF THE DRAWINGS

FIG. 1 is a process flow diagram of the process of the present invention.
FIGs. 2A and 2B are a cross-section of a DRAM device illustrating the effect of the phosphorus implant on the location of the junctions.
FIG. 3 compares the leakage current of two DRAM devices in which the source and drain were formed using a single arsenic implant with a third DRAM device in which the source and drain were formed using the process of the present invention.
FIG. 4 illustrates the effect of the phosphorus implant energy on the drain current as a function of gate voltage for 0.18 µm DRAM field effect transistors (FETs).
FIG. 5 illustrates the effect of the phosphorous implant energy on the current/voltage (I/V) characteristics of a 0.16 µm logic FET.
FIG. 6 compares the effect of the process of the present invention on the I/V characteristics of a 0.16 µm DRAM FET with a 0.18 µm DRAM FET.

### DETAILED DESCRIPTION

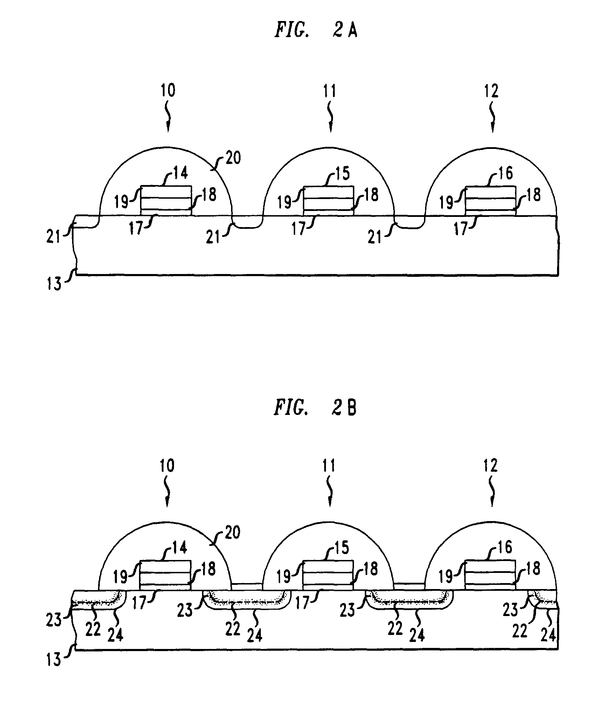

The process of the present invention is now described with reference to FIGS 2A and 2B. FIG. 2A is a cross section of DRAM devices at the point in the process sequence after the arsenic implant to form the source and drain regions and before the anneal to distribute the arsenic dopant in the substrate. Specifically, FIG. 2A illustrates three DRAM devices, 10, 11 and 12 formed on silicon substrate 13. Devices 10, 11, and 12 have gate stacks 14, 15 and 16, respectively, formed thereon. The gate stacks 14, 15 and 16 are depicted as two layers of polycrystalline silicon 18, 19 (doped to be conductive) formed on a layer of gate oxide 17. The gate stack structure depicted in FIG. 2A is illustrative. Gate structures typically have one or more layers of conductive material. A variety of gate stack structures are well known to one skilled in the art.

In the embodiment illustrated in FIG. 2A, source and drain extensions were not formed in the substrate region after the gate stacks, 14, 15 and 16 were formed. In alternate embodiments, dopants are implanted into the substrate after the gate stacks are formed to form source and drain extensions.

Referring to FIG. 2A, a layer of dielectric material (e.g. silicon nitride) 20 is formed over the structure. The dielectric material layer 20 is then etched anistropically to expose substrate regions in which the sources and drains of the devices 10, 11 and 12 will be formed. Arsenic is then implanted into the substrate regions exposed through silicon nitride layer 20 to form the source and drain regions 21. The implant conditions are selected to provide a junction with a depth of about 0.1 µm to about 0.15 µm. The energy and dose of the implant that are required to form such junctions are well known to one skilled in the art. Implant energies of about 30 keV to about 50 keV are contemplated as suitable.

The arsenic implant introduces damage into the substrate. Damage is in the form of defects in the crystal lattice of the substrate 13. After the arsenic implant, the resulting structure is annealed to further distribute the dopants in the substrate. Suitable conditions for this anneal are well known to one skilled in the art. After the arsenic implant and subsequent anneal, the placement of the source or drain junction and the placement of the damage from the arsenic implant are fixed and in known relation to each other. During the arsenic implant, the crystalline silicon substrate is amorphized. The amorphized implanted region has a shape and placement similar to 21 in FIG. 2A. Its depth is determined uniquely by the energy of the arsenic implant, and is determined with a formula well known to one skilled in the art and not described herein. Published tables are also available to determine the placement of the amorphized region caused by the arsenic implant.

During the thermal annealing steps after the arsenic implant, the amorphized region is recrystallized in such a manner that epitxial layers are grown from the underlying crystalline substrate. Since the amorphized region has a boundary that has several different crystalline orientations (referring to 21 of FIG. 2A), e.g. <100>, <110>, <111>, etc., the epitaxial growth is not uniform. Consequently, crystalline defects are created in the region after the growth. The defects created in this process are mostly stacking faults. In addition to the stacking faults, point defects are also created during the implant. These point defects are placed deeper in the substrate than the amorphized region, but within about 10 nm to about 50 nm of the amorphized region. During the subsequent annealing step, dislocations are formed in the vicinity of these point defects.

Referring to FIG 2B, the location of the junction before the phosphorus implant is illustrated by dashed line 22. The damage from the arsenic implant is illustrated as the shaded area 23 in the vicinity of dashed line 22.

A phosphorus implant is then performed. As illustrated by line 24, after the phosphorus implant, the location of the junction is moved relative to its previous location illustrated by dashed line 22. The conditions for the phosphorus implant are selected to move the location of the junction as defined by solid line 24.

The phosphorus implant conditions required to move the junction depend upon the distribution of the arsenic dopant in the substrate. The distribution of the dopant as a function of depth in the substrate is referred to as the dopant profile. The depth of the dopant is expressed as the distance below the surface at which the peak dopant concentration in the dopant profile is located. In order to move the junction, the depth of the peak phosphorus concentration is greater than the depth of the peak arsenic concentration (after implant and subsequent anneal) prior to the phosphorus implant. Phosphorus has a much higher diffusivity in silicon than arsenic. Consequently, the implant sequence is required to be arsenic implant first and phosphorus implant second. This is because the dosage of the first (arsenic) implant must be at least 1 x 10¹⁵ atoms/cm² in order to render the sheet resistance of the source and drain regions suitably low. If the phosphorus were implanted at such a high dose, the phosphorus would diffuse so deeply into the substrate that severe short channel effects would result. The second phosphorus implant has a dose in the range of about 5 x 10¹² atoms/cm² to about 5 x 10¹⁴ atoms/cm².

### Example 1

DRAM devices with a gate length of 0.18 µm were fabricated. Three devices were fabricated. The three devices were identical except for the ion implantation conditions used to form the source and drain of the device. One device was formed using a single arsenic implant. The implant energy was 50 keV and the dose was 3.2 x 10¹⁵ atoms/cm². A second device was formed using a single arsenic implant. The arsenic implant energy was 30 keV and the dose was 3.2 x 10¹⁵ atoms/cm² for the second device. A third device was formed using an arsenic implant followed by a phosphorus implant. The arsenic implant energy was 30 keV and the dose was 3.2 x 10¹⁵ atoms/cm². The phosphorus implant energy was 75 keV and the dose was 4.8 x 10¹⁵ atoms/cm².

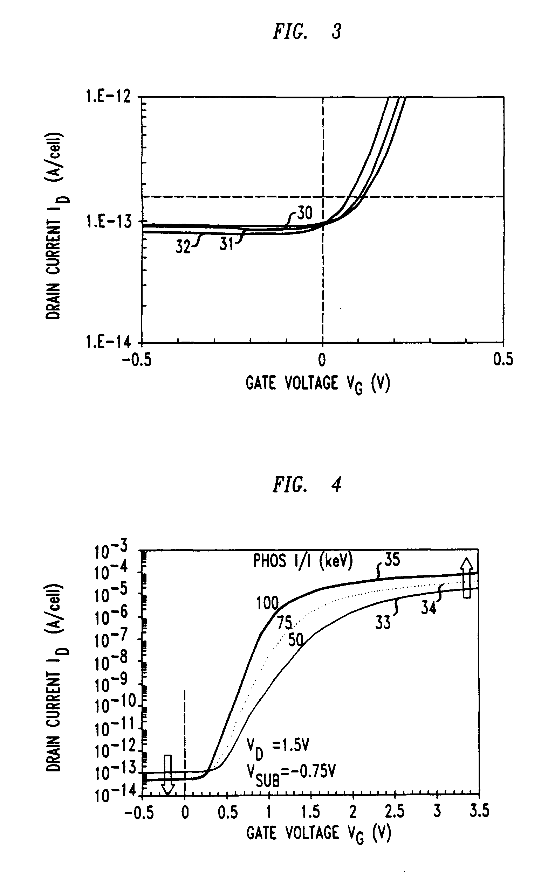

The drain current as a function of gate voltage (referred to as an I/V curve) was determined for the three devices. The devices were tested at a temperature of 125°C. The source voltage (Vₛ) applied to the devices was zero volts (Vₛ = 0). The drain voltage (V_{D}) was 1.5 volts (V_{D} = 1.5 volts). The substrate bias (V_{BS}) was -0.75 volts (V_{BS} = -0.75 volts). The gate voltage (V_{G}) was in the range -0.5 volts to -3.5 volts (V_{G} =-0.5V to -3.5V). The drain current, I_{D} (in amps per device), is illustrated as a function of the gate voltage in FIG. 3. I/V curve 30 is for the device formed with the single 50 keV arsenic implant. I/V curve 31 is for the device formed with the single 30 keV arsenic implant. I/V curve 32 is for the device formed with the dual arsenic/phosphorus implant. FIG. 3 illustrates that, for values of V_{G} less than 0 V, the drain current is fairly constant for all three devices. Specifically, the drain current for V_{G} < 0 volts for is for the devices in which the source and drain were formed by a single arsenic implant was about 90 fA/cell. The drain current for V_{G} < 0 volts for the device in which the source and drain were formed using a dual arsenic/phosphorus implant was about 80fA/cell. Thus the leakage current for the devices formed using the dual arsenic/phosphorus implant was less than the leakage current of the devices formed using the single implant. Also, Fig. 3 illustrates that drain current as a function of V_{g} begins to increase rapidly at values of V_{g} greater than 0.1 volts. The increase in drain current as a function of V_{g} for the device formed using the dual arsenic/phosphorus implant was faster than for the devices formed using the single arsenic implant.

The effect of the energy of the phosphorus implant was also evaluated. Three 0.18 µm DRAM devices were fabricated as previously described. The source and drain regions for all three devices were formed using an arsenic implant at an energy of 30 keV and a dose of 3.2 x 10¹⁵ atoms/cm². In the first device, the arsenic implant was followed by a phosphorus implant at a dose of 4.8 x 10¹³/cm² and energy of 50 keV. In the second device, the arsenic implant was followed by a phosphorus implant at a dose of 4.8 x 10¹³/cm² and an energy of 75 keV. In the third device, the arsenic implant was followed by a phosphorus implant at a dose of 4.8 x 10¹³/cm² and an energy of 100 keV.

The drain current as a function of gate voltage was determined for these three devices using the conditions previously described. The drain current I_{D} (in amps per device) is illustrated as a function of V_{G} in FIG. 4. The I/V curves of FIG. 4 illustrate the drain current of these devices in both the on and off states of the device. The off-current is defined as the drain current at V_{G}=0.

FIG. 4 illustrates that the leakage current (the drain current in the device off state) for the device made with the 100 keV phosphorus implant (determined from the I/V curve 35) was less than the leakage current for the devices formed using either the 75 keV phosphorus implant (I/V curve 34) or the 50 keV phosphorus implant (I/V curve 33). This is because the higher implant energy pushed the junction deeper into the substrate and, consequently, away from the defects caused by the implant. The I/V curves of FIG. 4 also illustrate that the energy of the phosphorus implant affected the V_{G} required to turn on the device.

Comparing the I/V curves of FIG. 4, the device formed using the 100 keV implant (I/V curve 35) clearly had a lower turn-on voltage than the devices formed using the 75 keV and 50 keV implants. Thus, the efficiency of the device increased with an increase in the energy of the phosphorus implant. Although applicants do not wish to be held to a particular theory, applicants believe the increased efficiency is attributed to the increased distance that the device junction was moved (relative to the damage caused by the arsenic implant) by the higher energy phosphorus implant. For a given phosphorus dose, the depth of the peak phosphorus concentrated in the substrate will increase with an increase in implant energy.

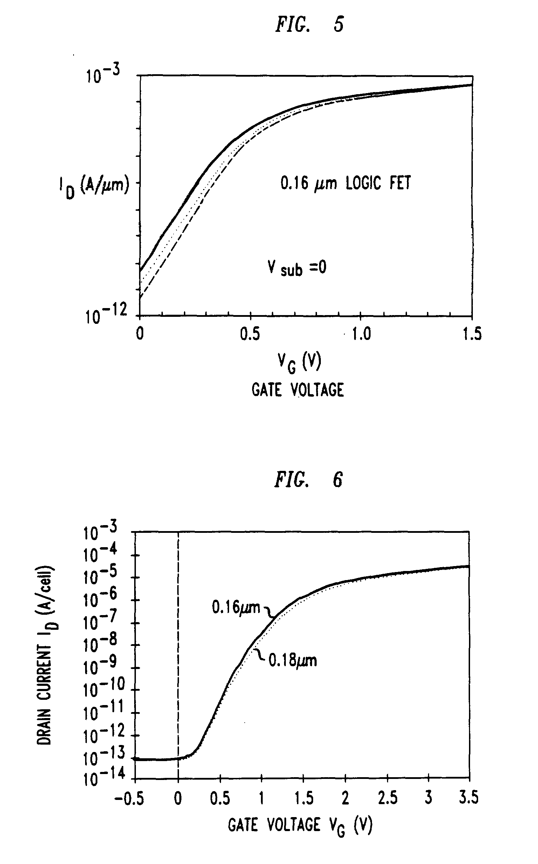

The effect of the energy of the phosphorus implant on the logic FET device was also evaluated. Three 0.16 µm logic FETs were fabricated. In the first device, the arsenic implant was followed by a phosphorus implant at a dose of 4.8 x 10¹³/cm² and an energy of 50 keV. In the second device, the arsenic implant was followed by a phosphorus implant at a dose of 4.8 x 10¹³/cm² and an energy of 75 keV. In the third device, the arsenic implant was followed by a phosphorus implant at a dose of 4.8 x 10¹³/cm² and an energy of 100 keV. The drain current (I) of the devices as a function of the gate voltage (V) was determined. The resulting I/V curves 23, 24 and 25 for the three devices are illustrated in FIG. 5. FIG. 5 illustrates that the energy of the phosphorus implant had negligible effect on the I/V curves for the three devices. All three devices have an off current of less than 1 nA/device.

The effect of the phosphorus implant on the drain current as a function of gate voltage (i.e. the I/V curve) on a 0.18 µm DRAM device was compared to the effect of the phosphorus implant on a 0.16 µm DRAM device. For both devices, the arsenic implant conditions were an implant energy of 30 keV and a does of 3.2 x 10¹⁵ atoms/cm². The I/V curves for the two devices were essentially identical, as illustrated in FIG. 6.

While this invention has been described with reference to certain illustrative embodiments, one skilled in the art will appreciate that modifications to the embodiments may be made without departure from the spirit and scope of the invention.

## Claims

1. A process for device fabrication comprising:
forming an n-type region in a semiconductor substrate;
forming a transistor gate over the n-type semiconductor region;
implanting arsenic into the n-type semiconductor substrate region with the transistor gate formed thereon wherein the energy of the arsenic implant is about 30 keV to about 50 keV and the dose of the arsenic implant is at least about 3 x 10¹⁵ atoms/cm² and wherein a source region and a drain region, each having a junction boundary associated therewith, are defined in the substrate by the implanted arsenic; and
implanting phosphorus into the n-type semiconductor substrate, wherein the dose and implant energy of the phosphorus implant are selected to move the junction boundary further into the substrate.

2. The process of claim 1 further comprising forming dielectric spacers adjacent to the transistor gate prior to the arsenic implant.

3. The process of claim 2 further comprising annealing the substrate after the arsenic implant at a temperature of at least about 900°C.

4. The process of claim 3 further comprising determining a damage region in the substrate after the arsenic implant and selecting phosphorus implant conditions to move the junction out of the damage region.

5. The process of claim 1 wherein the phosphorus implant conditions are selected so that the peak concentration of the phosphorus in the substrate after the implant is located deeper into the substrate than the peak concentration of the arsenic in the substrate.

6. The process of claim 1 wherein the energy of the phosphorus implant is in the range of about 50 keV to about 200 keV and the dose is in the range of about 1 x 10¹² atoms/cm² to about 1 x 10¹⁵ atoms/cm².
